# EUROPÄISCHE PATENTANMELDUNG

(11) **EP 4 685 689 A1**
(43) Veröffentlichungstag der Anmeldung: **28.01.2026**
(21) Anmeldenummer: 24190716.1
(22) Anmeldetag: 24.07.2024
(51) Int. Cl.: G06J 1/00, G06G 7/00, H03M 1/06

(54) **RECHENSCHALTUNG UND VERFAHREN**

(71) Anmelder: Deutsches Zentrum für Luft- und Raumfahrt e.V., 53227 Bonn (DE)
(72) Erfinder: Fritzsche, Johannes, 89081 Ulm (DE); Beil, Martin, 89081 Ulm (DE); Baberuxki, Nick, 89081 Ulm (DE); Dahlmann, Karl-Heinz, 89081 Ulm (DE)
(74) Vertreter: noventive Patentanwaltsgesellschaft mbH

(57) **Zusammenfassung**

Rechenschaltung (1), insbesondere einer Analogrecheneinrichtung (20), weiter insbesondere einer analog-digitalen Hybridrecheneinrichtung (30), aufweisend einen Analogrechenschaltkreis (50), ausgebildet und eingerichtet, um eine analoge Rechenoperation auszuführen; und aufweisend eine Detektions- und Kompensationsschaltung (I) sowie eine temporäre analoge Speicherschaltung (Engl.: Sample and Hold Circuit, SH), ausgebildet und eingerichtet, um im Analogrechenschaltkreis eine Offset-Rechenspannung (V1a) zu detektieren und um eine Kalibrierung in Bezug auf die Offset-Rechenspannung (V1a) durchzuführen.

## Beschreibung

Die Erfindung betrifft eine Rechenschaltung. Die Erfindung betrifft eine analog-digitale Hybridrecheneinrichtung. Die Erfindung betrifft ein Verfahren.

Optimierungen von Rechenschaltungen sind im Stand der Technik bekannt. Die US 4,399,426 A beschreibt ein Verfahren und eine Vorrichtung, um Fehler zu korrigieren, die in einem Datensammelsystem erzeugt werden. Die WO 2010 062 547 A1 beschreibt eine Autokalibration analoger Schaltkreise welche durch eine Nutzeranfrage oder automatisch, nach Eintritt eines Events, initialisiert werden kann. Die US 7,209,013 A beschreibt eine Eigenkalibration integrierter Schaltkreise, welche mittels eines Prozessors, der mindestens eine analoge Funktion und einen oder mehrere Sensoren für die Kalibration aufweist. Die beschriebenen Ansätze werden indes in Bezug auf die Durchführung von Rechenoperationen und dazu notwendige Vorbereitungen in den Schaltkreisen als unbefriedigend empfunden.

Die Aufgabe der Erfindung besteht insbesondere darin, die Vorbereitung der beschriebenen Rechnerarchitekturen, insbesondere in Hinblick auf analog-digitale Hybridrecheneinrichtungen, zu verbessern, insbesondere um mögliche Fehlerquellen bei der Durchführung von Rechenoperationen in analogen und/oder analog-digitalen Hybridrechnerarchitekturen zu reduzieren, um sowohl die Performance als auch die Zuverlässigkeit dieser Rechnerarchitekturen zu verbessern.

Die Aufgabe wird insbesondere gelöst durch eine Rechenschaltung gemäß Anspruch 1. Die Aufgabe wird insbesondere gelöst durch eine analog-digitale Hybridrecheneinrichtung gemäß Anspruch 6. Die Aufgabe wird gelöst durch ein Verfahren gemäß Anspruch 8. Vorteilhafte Ausführungsformen der Erfindung sind Gegenstand der abhängigen Ansprüche, der Beschreibung und der Figuren. Merkmale, Merkmalskombinationen, technische Effekte und Vorteile, die im Zusammenhang mit der Rechenschaltung beschrieben sind, gelten auch für die Rechenschaltung, das Verfahren und/oder die analog-digitale Hybridrecheneinrichtung. Sie können entsprechend auf eine analoge Recheneinrichtung, eine Speichereinrichtung und/oder ein elektronisches Signal übertragen werden. Dies gilt auch umgekehrt, so dass im Hinblick auf die Offenbarung der einzelnen Aspekte der Erfindung stets wechselseitig Bezug genommen wird bzw. werden kann, insbesondere unabhängig von der beschriebenen und/oder beanspruchten Kategorie.

Gemäß einem Aspekt wird die Aufgabe insbesondere durch eine Rechenschaltung mit den Merkmalen des Anspruchs 1 gelöst.

Eine Rechenschaltung kann dazu ausgebildet und eingerichtet sein, analoge Rechenoperationen auszuführen. Alternativ oder zusätzlich kann eine Rechenschaltung ausgebildet und eingerichtet sein, digitale Rechenoperationen auszuführen. Die Rechenschaltung kann Teil einer Analogrecheneinrichtung sein. Die Rechenschaltung kann Teil einer analog-digitalen Hybridrecheneinrichtung sein. Eine Rechenschaltung weist insbesondere eine Anzahl von Schaltungen und/oder Bauelementen auf, die zusammenarbeiten, um eine bestimmte Berechnung durchzuführen. Die Rechenschaltung weist insbesondere eine Detektions- und Kompensationsschaltung sowie eine temporäre analoge Speicherschaltung auf (Engl.: Sample and Hold Circuit), die ausgebildet und eingerichtet sein kann, um im Analogrechenschaltkreis eine Offset-Rechenspannung zu detektieren und um eine, insbesondere zeitweise gültige, Kalibrierung in Bezug auf die Offset-Rechenspannung durchzuführen. Dadurch können Offset-Fehler korrigiert werden, insbesondere in allen Routen möglicher Rechenoperationen einer Rechenschaltung.

Offset-Fehler in elektronischen Rechenschaltungen sind insbesondere unerwünschte Gleichspannungsniveaus, die besonders an den empfindlichen Eingangsstufen von Operationsverstärkern entstehen können und schließlich an deren Ausgängen störend in Erscheinung treten. Da sich selbst Operationsverstärker gleicher Bauart in ihren elektrischen Eigenschaften nie exakt gleichen, kann der genaue Wert der Offsetgrößen nicht exakt vorbestimmbar sein. In Rechenschaltungen führt dieser Offset insbesondere zu bedeutenden Rechenfehlern. Offsets können durch geeignete Maßnahmen reduziert, aber nie ganz eliminiert werden. Erschwerend kommt hinzu, dass Offset-Größen sowohl temperaturabhängig sind als auch einer alterungsbedingten Drift unterliegen können.

Diesem Umstand kann durch die hier und an anderer Stelle hierin beschriebenen Aspekte und/oder Ausführungsbeispiele in ihrer jeweiligen Gesamtheit, in der Gesamtheit aller Aspekte, aber auch in aus den Aspekten isolierten Teilen, insbesondere nach Kombination mit anderen Teilen aus den Aspekten, solange technisch sinnvoll und für den Fachmann aus der hiesigen Beschreibung, den Ansprüchen und den Figuren herleitbar, entgegengewirkt werden. Somit kann es möglich sein, die verschiedenen Merkmale, Vorteile und Effekte entsprechend aus dem Zusammenhang, in dem sie beschrieben sind zu lösen, um diese auch in Kombinationen zu beanspruchen, die für eine entsprechende Lösung der hierin beschriebenen Probleme und Aufgaben geeignet sind.

Eine Analogrecheneinrichtung (auch analoge Recheneinrichtung genannt) ist insbesondere eine Art von Rechenschaltung(en), die dazu bestimmt ist/sind, analoge Signale zu verarbeiten. Dabei werden die Signale insbesondere nicht digitalisiert und insbesondere nicht in feste, diskrete Zahlenwerte umgewandelt, sondern insbesondere direkt (weiter)verarbeitet.

Eine Digitalrecheneinrichtung (auch digitale Recheneinrichtung genannt) ist insbesondere eine Art von Rechenschaltung(en), die mit diskreten Werten arbeiten kann, wie dies etwa in den siliziumbasierten Chips von Rechnern, Computern oder ähnlichen Systemen durchgeführt werden kann.

Eine analog-digitale Hybridrecheneinrichtung kombiniert insbesondere Elemente (sprich auch Vorrichtungen) beider Systeme - analoger und hybrider Recheneinrichtungen - und kann sowohl analoge als auch digitale Berechnungen durchführen. Sie ist insbesondere nützlich, wenn man eine bestimmte Funktionalität in einem analogen Teil der Schaltung ausführen und die Ergebnisse in einen digitalen Teil weitergeben möchte oder entsprechend umgekehrt. Dadurch können Aufgaben gelöst werden, die ein entsprechendes System alleine nicht abbilden kann oder ggf. nicht mit gleicher Qualität abbilden kann.

Ein Analogrechenschaltkreis ist die speziell für mindestens eine analoge Rechenoperation ausgebildete und eingerichtete Vorrichtung. Ein solcher Schaltkreis kann zum Beispiel dazu verwendet werden, zwei analoge Signale zu addieren oder zu subtrahieren, um zwei einfache Beispiele zu nennen.

Eine analoge Rechenoperation ist insbesondere eine Berechnung, bei der die Eingaben und das Ergebnis in analogen Formen vorliegen. Beispiele für analoge Rechenoperationen sind Addition, Subtraktion, Multiplikation, Division und Integration.

Zur Ermittlung von Offset-Rechenspannungen wird insbesondere eine Detektions- und Kompensationsschaltung sowie insbesondere eine temporäre analoge Speicherschaltung (Engl.: Sample and Hold Circuit) im Analogrechenschaltkreis eingesetzt. Diese Schaltung detektiert insbesondere die Offset-Rechenspannung und ist in der Lage, in Bezug auf diese eine Kalibration einer Recheneinrichtung, eines Schaltkreises oder ähnliches durchzuführen, um sicherzustellen, dass die Genauigkeit der kalibrierten Vorrichtung aufrecht erhalten bleibt, da die Offset-Rechenspannung bei der Berechnung berücksichtigt werden kann. Durch den Einsatz von Detektions- und Kompensationsschaltungen kann eine hohe Genauigkeit bei analogen Rechenoperationen erreicht werden. Dies ist insbesondere in Anwendungen wie Mess- und Steuerungssystemen, wo hohe Präzisionen erforderlich sind, von Bedeutung, aber auch bei entsprechenden Systemen, die für die Berechnung und Lösung mathematischer Problemstellungen vorgesehen sind.

Eine temporäre analoge Speicherschaltung kann insbesondere derart ausgebildet und eingerichtet sein, dass durch ein Samplen, auch als Folgen oder Tracking bezeichenbar, eine Offset-Rechenspannung in der Speicherschaltung über einen Zeitraum, der insbesondere für die Speicherschaltung spezifisch sein kann, derart gespeichert werden kann, dass bei einem Umschalten in einen Rechenbetrieb der Rechenschaltung, diese Offset-Rechenspannung, die insbesondere von an anderer Stelle hierin beschriebenen Offset-Fehlern, etwa durch bauteilbedingte Fehler oder entsprechende Produktionsungenauigkeiten, nicht mehr zu der etwaigen in der Rechnung verwendeten Spannung hinzukommen. Dadurch können etwaige durch die Offset-Rechenspannung sonst ggf. bedingte Rechenungenauigkeiten reduziert werden.

Nach einem weiteren Aspekt kann die Detektions- und Kompensationsschaltung eine Rückkopplungsschleife aufweisen. Diese Rückkopplungsschleife ist insbesondere ausgebildet und eingerichtet, um einen Kompensationswert für die Offset-Rechenspannung zu ermitteln.

Durch die Verwendung einer Rückkopplungsschleife kann die Detektions- und Kompensationsschaltung in der Lage sein, die Offset-Rechenspannung genau zu kalibrieren und so eine höhere Genauigkeit bei den analogen Rechenoperationen zu erreichen. Dies ist besonders wichtig in Anwendungen wie Messgeräten oder Steuerungen, wo hohe Präzisionen erforderlich sind.

Insbesondere kann die Rückkopplungsschleife als öffen- bzw. schließbare Regelschleife ausgebildet sein. Mit der verwendeten analogen Offsetkompensation in geschlossener Regelschleife kann beim Sampling - der Detektion - und dem Halten der Offsetgröße - des Wertes der Offset-Rechenspannung - in offener Regelschleife bei der Rechnung der Offset des Rechenpfades während der Rechnung effizient kompensiert werden. Die Sample and Hold Architektur ermöglicht zu diesem Zweck eine temporäre analoge Speicherung der Offsetgrößen. Die geschlossene Regelschleife ermöglicht die automatische Justierung und Nachregelung eines exakten Kompensationsstromes ohne Nutzung von Ressourcen des Hybridcontrollers. Das trägt insbesondere zu einer effizienten Kalibrierung analogdigitaler Hybridrechner bei. Dabei kann ein Zugriff auf die Rechenkapazität der Hybridcontrollerarchitektur vermieden werden und die Kalibration erfolgt insbesondere automatisch vor analogen Rechnungen.

Nach einem weiteren Aspekt kann die Detektions- und Kompensationsschaltung mit Hilfe der analogen, temporären Speicherschaltung (Engl.: Sample and Hold Circuit) den Kompensationswert halten. In einer solchen Rechenschaltung ist insbesondere die Detektions- und Kompensationsschaltung so ausgelegt, dass sie den Kompensationswert für die Offset-Rechenspannung hält und ihn während der Rechenoperation zur Kompensation verwendet. Dadurch kann sichergestellt werden, dass die analogen Rechenoperationen mit dem korrekten Kompensationswert durchgeführt werden können und eine höhere Genauigkeit zu erreichen.

Das Halten des Kompensationswerts kann beispielsweise über einen speziellen Speicherbaustein oder eine spezielle Schaltung realisiert werden, die den Wert bei Bedarf zur Kompensation bereitstellt. Durch diese Maßnahme kann sichergestellt werden, dass die Rechenoperationen sowohl genau als auch effizient durchgeführt werden kann, ohne durch Offset-Fehler beeinträchtigt bzw. verfälscht zu werden.

Insgesamt ist das Halten des Kompensationswerts bei der Entwicklung und Implementierung von Analogrecheneinrichtungen bzw. analog-digitalen Hybridrecheneinrichtungen von Bedeutung, um eine hohe Genauigkeit von Berechnungen zu ermöglichen, um eine verbesserte Rechenperformance zu erreichen.

Nach einem Aspekt kann die Rechenschaltung einen zusammenfassenden Kreuzungspunkt (Engl.: summing junction point, kurz SJP) aufweisen. Dieser Kreuzungspunkt ist insbesondere ausgebildet und eingerichtet, um während der analogen Rechenoperation einen Justagestrom zur Kompensation in Höhe des Kompensationswertes in den Analogrechenschaltkreis zu injizieren.

Der Justagestrom wird insbesondere über eine spezielle Schaltung in den Kreuzungspunkt (SJP) injiziert und dort mit dem Rechensignal kombiniert, um den Offset-Fehler zu korrigieren , während die Rechenoperation durchgeführt wird. Der Kompensationswert stellt sich dabei so ein, dass er die Offset-Rechenspannung ausgleicht und eine höhere Genauigkeit bei der Berechnung gewährleistet, insbesondere ohne die Rechnung durch die sonst ggf. vorliegende Offset-Rechenspannung zu verfälschen.

Nach einem Aspekt kann die Rückkopplungsschleife ausgebildet und eingerichtet sein, um als geschlossene Regelschleife beim Ermitteln - entspricht auch einem Folgen - (Engl.: Tracking) und/oder als offene Schleife beim Halten (Engl.: Holding) der Offsetgröße als Kompensationswert, die Offset-Rechenspannung bei der Analogrechenoperation zu kompensieren.

Alternativ zu Sample and Hold kann auch das Begriffspaar Track and Hold für die technische Bezeichnung verwendet werden. Das Begriffspaar Sample and Hold erlaubt begrifflich zu präzisieren, dass die hier und an anderer Stelle hierin beschriebene Schaltung die Fähigkeit hat, dem sich ändernden Wert der Offsetspannung insbesondere solange zu folgen (sprich ihn zu tracken), wie sie sich im Sample(Track)-Mode befindet. Alternativ kann das Begriffspaar Track and Hold benutzt werden, bzw. anstelle des Begriffs Hold auch in Abgrenzung zu diesem der Begriff Inject genutzt werden, da in der hier und an anderer Stelle hierin beschriebenen Schaltung im Hold-(Inject-)Mode ein Strom in einen Knoten (SJP) injiziert werden kann. Der Begriff Hold / Halten kann alternativ oder zusätzlich auch einen Rechenzustand der Schaltung beschreiben. Durch die Verwendung des Begriffs Inject kann einer Verwechslung mit einem reinen Halten vorgebeugt werden.

Die Rückkopplungsschleife wird dabei insbesondere so ausgelegt und eingerichtet, dass sie sowohl beim Ermitteln des Kompensationswertes als auch beim Halten desselben in der Lage ist, die Offset-Rechenspannung zu kompensieren. Durch diese Maßnahme kann sichergestellt werden, dass die analogen Rechenoperationen mit dem korrekten Kompensationswert durchgeführt werden und eine hohe Genauigkeit erreicht werden kann.

Die geschlossene Regelschleife wird insbesondere verwendet, um den Kompensationswert zu ermitteln. Die Sample and Hold Schaltung folgt als Bestandteil der geschlossenen Regelschleife im Track-Mode kontinuierlich dem ermittelten Kompensationswert und friert diesen erst beim Übergang in den Hold- bzw. Inject-Mode in einem Speicherelement (Speicherkondensator) ein. Unter dem Begriff eines "Einfrierens eines Kompensationswertes" wird insbesondere verstanden, dass der zuletzt ermittelte Wert für eine bestimmte Zeit, insbesondere die Rechenzeit vorgehalten werden kann, damit der Wert insbesondere während der Zeit in der die Rechnung durchgeführt wird, zur Verfügung steht, um eine Kompensation durchführen zu können. Es wird also insbesondere der Feeback-Strom in der Schaltung erzeugt und gehalten, der es ermöglichen kann, dass ohne eine Rechenoperation, insbesondere seitens des Hybridcontrollers, eine Spannung an einem definierten Knoten (SJP) auf das definierte Potential NULL gesetzt werden kann. Damit kann die Wirkung einer Offsetspannung kompensiert werden.

Hier und an anderer Stelle kann der Hybridcontroller genutzt werden, um den Vop - Mode zu steuern, wie er an anderer Stelle hierin beschrieben ist. Es kann Ausführungsformen geben, in denen der Hybridcontroller nicht zum Einsatz kommt, wobei ein Steuern des Vop über eine digitale Schaltung und/oder eine Rechenschaltung erfolgen kann.

Die offene Schleife kann hingegen beim Halten des Kompensationswertes eingesetzt werden, um sicherzustellen, dass der Kompensationswert für die Zeit während der Rechenoperation zur Verfügung stehen kann -indem ein entsprechender Korrekturstrom weiterhin fließt. Eine Hold-Phase bezieht sich dabei insbesondere auf einen Zeitraum, über den eine entsprechenden Kompensation hinreichend genau möglich ist. Während dieser Hold-Phase, also beispielsweise in einem "Operation-Mode" (kurz: OP-Mode), kann (nun) ein beliebiges neues Ausgangssignal der nun offsetbereinigten Route als Spannung vorliegen. Dieses kann über einen der Schalter einem Schaltungsblock der Rechenschaltung offsetbereinigt zugeführt werden. Der an anderer Stelle hierin beschriebene Speicherkondensator kann nun durch eine Schalterstellung von einer Verbindung mit einem Schalter, Verstärker oder Spannungsquelle getrennt sein, mit der zuvor eine Verbindung bestand, kann jedoch weiterhin das ursprünglich gesampelte Abbild einer Offsetspannung halten. Via einem weiteren Widerstand kann weiterhin in den Knoten (SJP) der beim Sampling ermittelte Kompensationsstrom injiziert werden. Der Knoten (SJP) wird insbesondere durch das Fließen eines Kompensationsstroms vom Knoten (SJP) auf dem Potential NULL gehalten. Das Ausgangssignal einer Rechenschaltung kann dabei die von der Rechnungsanforderung erwarteten Werte annehmen, um die Berechnung insbesondere offsetbereinigt durchführen zu können. Der vorher eingeprägte Kompensationsstrom durch einen entsprechend angeordneten Widerstand kann unabhängig davon für die Dauer der Speicherzeit beibehalten und in den Knoten injiziert werden. Der Offset der Route bleibt weitgehend für die Dauer der Speicherzeit des Speicherelements (des Speicherkondensators) kompensiert. Dadurch kann insbesondere verhindert werden, dass ein Offset auf das entsprechend durch die Rechenoperation ausgegebene Ausgangssignal aufgeschlagen wird, was das Rechenergebnis abändern und verfälschen könnte. Derartige Verfälschungen und dadurch ggf. resultierende Fehler in der Rechenoperation können dadurch reduziert werden.

Es wird insbesondere von Abbild einer Offsetspannung gesprochen, da in der Schaltung Ströme verarbeitet werden, die entsprechend eine Abbildung von Spannungen darstellen können. Damit kann es sein, dass die Offsetspannung nicht entsprechend unmittelbar und direkt ausgegeben wird, sondern lediglich über die Wirkung auf die resultierenden Strömen und Spannungen "zu Tage tritt".

Nach einem unabhängigen Aspekt kann eine analog-digitale Hybridrecheneinrichtung eine Rechenschaltung wie an anderer Stelle hierin beschrieben aufweisen.

Eine analog-digitale Hybridrecheneinrichtung ist insbesondere eine Vorrichtung und/oder ein System, das sowohl analoge als auch digitale Rechenoperationen durchführen und dabei die Vorteile beider Systeme in Kombination nutzen kann. Die Rechenschaltung der analog-digitalen Hybridrecheneinrichtung ist insbesondere darauf ausgelegt, eine oder mehrere der oben definierten Aspekte zu implementieren, um eine hohe Genauigkeit und Stabilität bei den Berechnungen zu gewährleisten.

Die Rechenschaltung kann beispielsweise eine Detektions- und Kompensationsschaltung (Engl.: Sample and Hold Circuit) aufweisen, um die Offset-Rechenspannung zu detektieren und zu kompensieren. Sie kann auch einen zusammenfassenden Kreuzungspunkt (SJP für Engl.: summing junction point) aufweisen, um während der analogen Rechenoperation einen Justagestrom zur Kompensation in Höhe des Kompensationswertes in den Analogrechenschaltkreis einzuspeisen.

Zudem kann die Rechenschaltung auch eine Rückkopplungsschleife aufweisen, um als geschlossene Regelschleife beim Ermitteln (Engl.: Sampling) und/oder als offene Schleife beim Halten der Offsetgröße als Kompensationswert, die Offset-Rechenspannung bei der Analogrechenoperation zu kompensieren.

Insbesondere ist die Verwendung einer Rechenschaltung nach einem der voranstehenden Aspekte bei der Entwicklung und/oder Implementierung von analog-digitalen Hybridrecheneinrichtungen von Bedeutung, um eine hohe Genauigkeit und Stabilität in den Berechnungen zu gewährleisten und die Vorteile einer hybriden Architektur und damit einer Kombination der beschriebenen Architekturen zu nutzen, um insbesondere auch nicht-diskrete Berechnungen basierend auf entsprechenden Schaltungen ermöglichen zu können.

Die analog-digitale Hybridrecheneinrichtung kann dabei durch die Merkmale, Eigenschaften, Vorteile und Effekte der Rechenschaltung, wie sie an anderer Stelle hierin beschrieben ist, beschrieben werden. Dies gilt entsprechend auch umgekehrt, so dass die Rechenschaltung durch die Merkmale, Vorteile und Effekte der analog-digitalen Hybridrecheneinrichtung beschrieben werden kann. Entsprechendes gilt auch für das hierin beschriebene Verfahren, das auch über die Kategoriegrenzen Vorrichtung, System, Verfahren und Verwendung hinweg durch die Merkmale, Eigenschaften, Vorteile und Effekte der Rechenschaltung und/oder der analog-digitalen Hybridrecheneinrichtung beschrieben werden kann bzw. dessen Merkmale, Eigenschaften, Vorteile und Effekte die Rechenschaltung und/oder analog-digitalen Hybridrecheneinrichtung beschreiben kann.

Nach einem Aspekt kann die analog-digitale Hybridrecheneinrichtung - auch als ein Hybridrechner bezeichenbar - eine Rechenschaltung aufweisen, die insbesondere derart ausgebildet und eingerichtet ist, um eine Offset-Rechenspannung ohne Rückgriff auf eine Hybridcontrollerarchitektur zu kompensieren.

Dies bedeutet, dass die Rechenschaltung selbstständig in der Lage ist, die Offset-Rechenspannung zu detektieren und zu kompensieren, ohne dass separate Hybridcontroller erforderlich sind, bzw. ohne dass auf diese zurückgegriffen werden müsste. Dies kann durch den Einsatz von Detektions- und Kompensations- und Speicherschaltungen (Engl.: Sample and Hold Circuit) erreicht werden, die speziell ausgelegt sind, um einen Kompensationswert für die Offset-Rechenspannung zu ermitteln und zu halten, insbesondere wie an anderer Stelle hierin im Detail beschrieben.

Diese Art von Hybridrechner ist insbesondere in Anwendungen von Bedeutung, bei denen eine hohe Genauigkeit und Stabilität erforderlich ist und wo separate Hybridcontroller nicht dazu verwendet werden sollen, um eine entsprechende analoge Berechnung bzw. einen Teil einer Berechnung mit einem analogen Teil, zu beeinflussen. Durch die Verwendung einer entsprechenden Rechenschaltung können sowohl analoge als auch digitale Rechenoperationen durchgeführt werden, um eine hohe Genauigkeit und Stabilität der Berechnung ermöglichen zu können, insbesondere ohne dass separate Hybridcontroller erforderlich wären, um den analogen Berechnungsteil zu beeinflussen, etwa indem sie in Bezug auf die Offset-Fehlerkorrektur eingesetzt würden.

Insgesamt ist die Möglichkeit, eine Offset-Rechenspannung zu kompensieren, insbesondere ohne dass ein Rückgriff auf eine Hybridcontrollerarchitektur notwendig ist, ein Faktor bei der Entwicklung und Implementierung von Hybridrechnern und kann dazu beitragen, die Effizienz und Genauigkeit von analog-digitalen Hybridrechnern zu verbessern.

Nach einem unabhängigen Aspekt kann ein Verfahren zur Ermittlung und Kompensation einer Offset-Rechenspannung in einer Rechenschaltung ausgebildet sein. Die Rechenschaltung kann dabei ausgebildet und eingerichtet sein, wie an anderer Stelle hierin beschrieben. Das Verfahren kann den Schritt eines Ermittelns von mindestens einem Kompensationswert der Offset-Rechenspannung in der Rechenschaltung aufweisen. Dies kann insbesondere durch den Einsatz von mindestens einer Detektions- und Kompensations- und Speicherschaltung (Engl.: Sample and Hold Circuit) erfolgen, wie an anderer Stelle hierin beschrieben. Das Verfahren kann den Schritt eines Haltens des mindestens einen Kompensationswerts der Offset-Rechenspannung in der Rechenschaltung während einer Analogrechenoperation aufweisen, insbesondere um zu ermöglichen, dass die Offset-Rechenspannung kontinuierlich kompensiert wird. Das Verfahren kann den Schritt eines Einspeisens eines Kompensationsstromes zum Kompensieren einer Offset-Rechenspannung in der Rechenschaltung während einer Analogrechenoperation aufweisen, insbesondere um eine hohe Genauigkeit und Stabilität bei den Berechnungen zu gewährleisten.

Durch die Verwendung dieses Verfahrens können sowohl analoge als auch digitale Rechenoperationen durchgeführt werden und eine hohe Genauigkeit und Stabilität kann gewährleistet werden. Die Detektions- und Kompensationsschaltungen oder andere geeignete Vorrichtungen, Systeme, aber auch Verfahren ermöglichen es, den Kompensationswert der Offset-Rechenspannung (genau) zu ermitteln und während der Analogrechenoperation - auch im Rahmen einer Operation einer analog-digitalen Hybridarchitektur/Hybridrecheneinrichtung/Hybridrechner - konstant zu halten, um eine effiziente und genaue Berechnung sicherzustellen.

Insgesamt ist das Verfahren zur Ermittlung und Kompensation einer Offset-Rechenspannung in einer Rechenschaltung ein Aspekt der insbesondere bei der Entwicklung und Implementierung von analog-digitalen Hybridrecheneinrichtungen von Bedeutung ist, um eine hohe Genauigkeit und Stabilität der Berechnungen zu ermöglichen und um die Effizienz von analog-digitalen Hybridrechnern zu verbessern.

Eine Ausführungsform der Erfindung wird in der Figur gezeigt und im Folgenden ausführlicher erläutert. Es wird gezeigt in:
FIG. 1A eine exemplarische Ausführungsform einer Rechenschaltung einer analog-digitalen Hybridrecheneinrichtung;
FIG. 1B die exemplarische Ausführungsform der Rechenschaltung der analog-digitalen Hybridrecheneinrichtung, mit Vereinfachung der Darstellung zur Verdeutlichung eines Sample-Betriebs;
FIG. 1C die exemplarische Ausführungsform der Rechenschaltung der analog-digitalen Hybridrecheneinrichtung, mit Vereinfachung der Darstellung zur Verdeutlichung eines Operationsbetriebs;
FIG. 2 eine schematische Darstellung einer exemplarischen Ausführungsform eines Verfahrens zur Kompensation von Offset-Fehlern; und
FIG. 3 eine exemplarische Darstellung von Offsetkompensationen, die durch das Verfahren der FIG. 2, durchgeführt bei Verwendung der Vorrichtung der FIG. 1, ermöglicht werden.

Die FIGs enthalten, insbesondere teilweise vereinfachte, schematische Darstellungen. In einigen Fällen können identische Bezugszeichen für gleiche oder ähnliche, aber möglicherweise nicht identische Elemente verwendet werden. Unterschiedliche Ansichten der gleichen Elemente können unterschiedlich skaliert werden. Anweisungen wie "links", "rechts", "oben" und "unten" sind in Bezug auf die jeweilige Figur zu verstehen und können in den einzelnen Darstellungen im Vergleich zum abgebildeten Objekt variieren. Bei Darstellungen, die als vereinfacht angeführt sind, kann es sich insbesondere um Darstellungen handeln, die für das Verständnis von Ausführungsformen und/oder deren Zustände Bereiche und/oder Strukturen und/oder Merkmale nicht darstellen, um in Bezug auf deren Beschreibung und Erklärung den Fokus des Betrachters auf die erklärten Merkmale zu lenken, um das Verständnis zu fördern. Dem steht nicht entgegen, dass diese Merkmale, Strukturen und/oder Zustände, die in Bezug auf andere FIGs dargestellt und beschrieben sind entsprechend in der Ausführungsformen vorliegen können und/oder mit diesen kombiniert werden können.

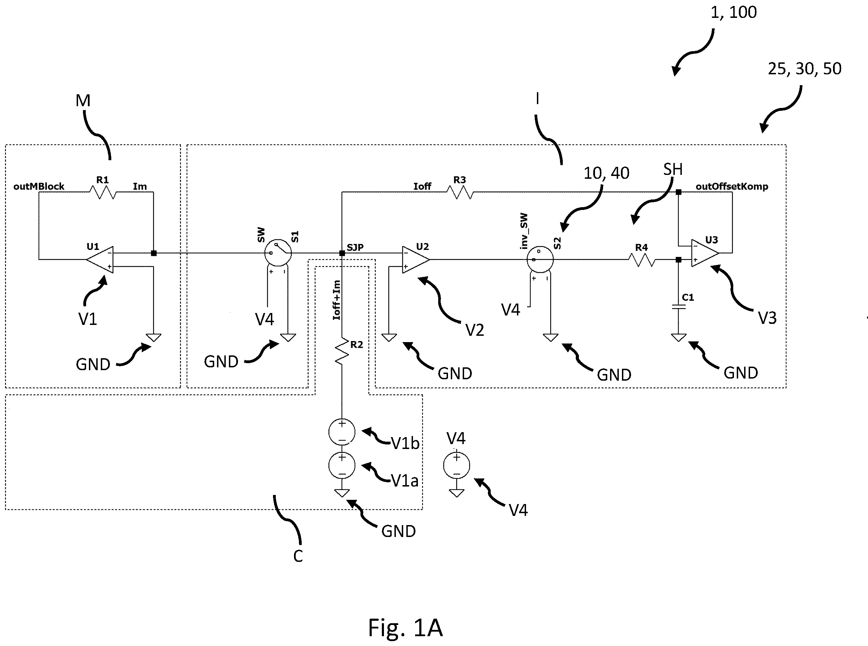

FIG. 1A zeigt eine Rechenschaltung 1 in einer analog-digitalen Hybridrecheneinrichtung 100, die per Design auf weitgehende Eliminierung der Gesamtheit aller Offsetrechenspannungen V1a hin optimiert worden sein kann. Die Rechenschaltung 1 weist dabei insbesondere Schaltungsblöcke auf, wobei hier drei Schaltungsblöcke exemplarisch dargestellt sind, um das Prinzip zu erklären. Dabei kann ein M-Block M vorgesehen sein, der hier beispielhaft für alle möglichen Rechenschaltungen steht, die offsetbereinigte Eingangsgrößen benötigen und hier insbesondere stromgespeist sind. Dabei kann ein Rechenpfad C vorgesehen sein, der hier beispielhaft für alle möglichen offsetbehafteten Rechenpfade stehen kann, die gedacht sein können, um eine konkrete Rechenschaltung (hier der M-Block) mit einer Eingangsgröße zu versorgen und dazu eine Spannungs-Strom-Umwandlung vorzunehmen. Dabei kann eine Offsetkompensationsschaltung I vorgesehen sein deren Kernelemente aus einer öffen- und schließbaren Regelschleife sowie einer Speicherschaltung (Sample and Hold Schaltung) bestehen können, deren Aufgabe es insbesondere ist, Offsetgrößen des Rechenpfades C auf dem Weg zum M-Block M zu kompensieren.

Der M-Block M ist dabei insbesondere als ein Matheblock vorgesehen, der durch seine Implementierung eine mathematische Operation erlaubt, wie hier etwa die Ausgabe der Identität als einfachste mathematische Operation. Es können verschiedene Arten mathematischer Operationen vorgesehen sein, wie etwa Integralbildung, Differenzbildung, Produktbildung, Differenzierung und alle möglichen denkbaren anderen mathematischen Operationen, da das hier vorgestellte Kompensationsprinzip der Sample-and-Hold-Schaltung SH auf andere Rechenschaltungen 1 übertragen werden kann, die entsprechend konfigurierte M-blöcke M aufweisen können.

Die Offsetrechenspannung V1a kann etwa durch Auswahl der verwendeten Komponenten minimiert werden. In einem entsprechenden Entwurf-Verfahren kann eine Designoptimierung der Architektur, wie auch der Dimensionierung der Komponenten erfolgen.

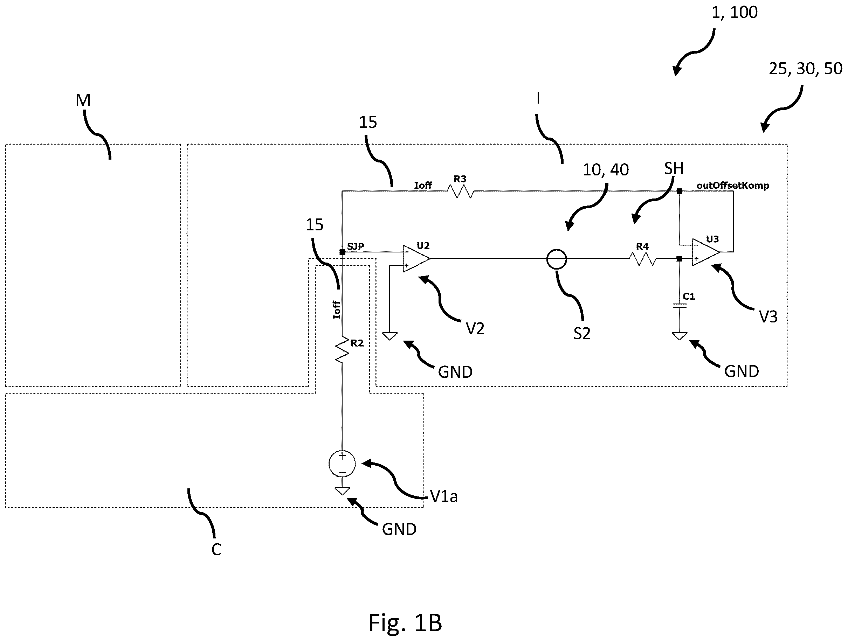

OP-Verstärker U1, U2, U3 werden insbesondere durch Betriebsspannungen V1, V2, V3 versorgt. V4 ist insbesondere eine Steuerspannung, die den Übergang vom Track- in den Injectmode mittels der von ihr angesteuerten Schalter S1, S2 realisieren kann. Wenn der Schalter S2 in FIG. 1A geschlossen wird (wie hier rein exemplarisch schon dargestellt), dann kann das in FIG. 1B dargestellte Routing ausgebildet werden, das ein Sampling der Offsetrechenspannung V1a ermöglicht. Dazu wird insbesondere ein Kompensationsstrom loff derart fließen, insbesondere über den Pfad 15, daß sich ein NULL-Potential am Knoten SJP einstellt. Dabei kann der Kondensator C1 entsprechend geladen werden, um einen derartigen Kompensationsstrom loff auszubilden, der insbesondere über den Port outOffsetKomp des Operationsverstärkers U3 fließen kann. Dadurch kann eine Rückkopplungsschleife über den Pfad 15 durch den Operationsverstärker U2, den geschlossenen Schalter S2, den Widerstand R4, den Operationsverstärker U3, den Widerstand R3 zum Knoten SJP gebildet werden, um dadurch einen Kompensationsstrom loff entsprechend einzuregeln.

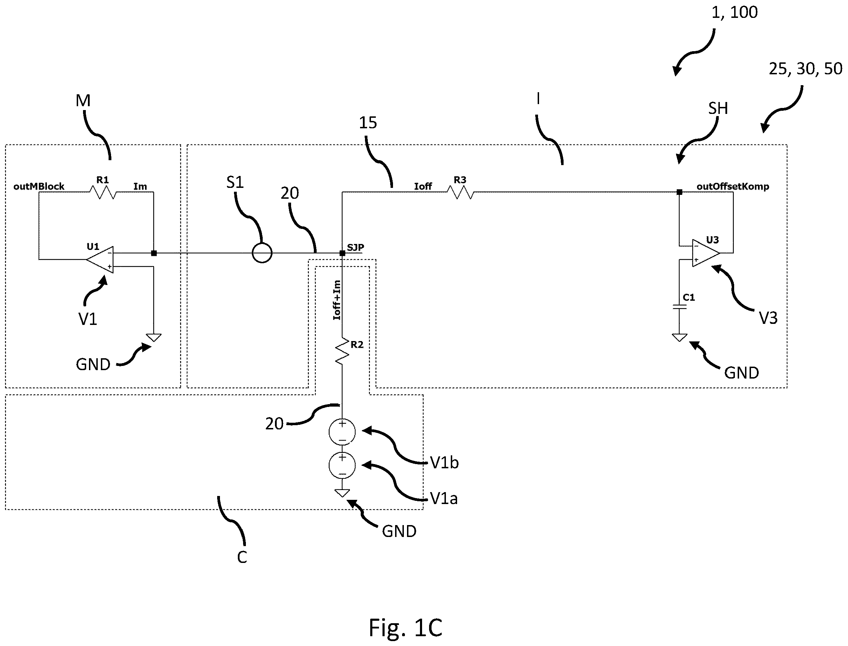

Dadurch kann die Wirkung der Summe aller aufgenommenen Offsetrechenspannungen V1a im System entsprechend auf NULL am Knoten SJP reguliert werden. Die Offsetrechenspannung U1a kann insbesondere durch bauteilbedingte Offsetspannungen an den individuellen Operationsverstärkern ausgangsseitig auftreten, die sich im Rechenpfad C entsprechend zur Rechenspannung V1b addieren können. In anderen Worten ausgedrückt kann sich die Offsetrechenspannung V1a insbesondere aus bauteilbedingten Offset-Fehlern der im Rechenpfad C eingebauten Operationsverstärker hervorgehen. Bei diesen Offset-Fehlern handelt es sich insbesondere um unerwünschte Gleichspannungsniveaus, die besonders an den empfindlichen Eingangsstufen von Operationsverstärkern entstehen können und schließlich an deren Ausgängen störend in Erscheinung treten können. Da sich selbst Operationsverstärker für den Fall, dass diese gleicher Bauart sind, in ihren elektrischen Eigenschaften nie exakt gleichen, kann der genaue Wert der Offsetgrößen als Offsetrechenspannungen U1a nicht exakt vorbestimmbar sein. In der Rechenschaltung 1 führt dieser Offset insbesondere zu (bedeutenden) Rechenfehlern, wenn er nicht kompensiert würde. Im Rechenzyklus kann in der dargestellten Rechenschaltung 1 die Wirkung der aufgenommenen Offsetspannungen V1a durch einen zusätzlich injizierten Strom loff in entgegengesetzter Richtung für den gerouteten Pfad 20 weitestgehend vollständig aufgehoben werden. Dazu wird insbesondere die Wirkung der Offsetrechenspannung V1a unmittelbar vor der Rechnung im Sample-Betrieb gemessen, und in einer temporär wirksamen, insbesondere analogen Speicherschaltung, einer Sample-and-Hold-Schaltung SH, die den Kondensator C1 aufweisen kann, gespeichert, wie entsprechend in der FIG. 1B dargestellt, um bei der Rechnung, im Hold-Betrieb bzw. im Operationsbetrieb, wie er in FIG. 1C dargestellt ist, mittels des Kompensationsstroms loff der Rechenschaltung 1 kompensiert zu werden, indem der Kompensationsstrom loff der Rechenschaltung 1 entnommen werden kann, um die Wirkung der Offsetrechenspannungen V1a, insbesondere in exakter Höhe, kompensieren zu können.

Zur Ausführung einer Rechenoperation (bzw. in Ausführungsformen zur Ausführung auch mehrerer Rechenoperationen) kann (mindestens) ein Strom Im über (mindestens) einen Pfad 20 fließen, wobei ein Rechenblock - auch als Matheblock oder M-Block M zu bezeichnen - eine Rechenschaltung aufweisen kann, die über einen entsprechend geschlossenen Schalter S1, wie er in den FIGs. 1A und 1C dargestellt ist, derart über den Pfad 15 mit der Sample-and-Hold-Schaltung SH verbunden werden kann, um den Hold- bzw. den Operationsbetrieb zu ermöglichen, in dem ein Rechenstrom Im fließt, der die Information der Rechenoperation (sowohl ein Eingangssignal für eine Rechenschaltung eines M-Blocks M als auch ein Ausgangssignal aus einer Rechenschaltung eines M-Blocks M sind in Ausführungsformen denkbar), die von eigentlichem Interesse ist, aufweisen kann. Dieser auch als Rechenstrom bezeichenbare Strom Im kann dabei durch die Rechenspannung V1b verursacht werden. Dieser Strom Im kann über den Pfad 20 laufen. Der Pfad 20 ist insbesondere der, insbesondere direkte, Weg von V1a, R2, S1, zum Rechenelement U1, wie dies in der FIG. 1C dargestellt ist. Dabei ist der Schalter S1 insbesondere geschlossen, während der Schalter S2 (in FIG. 1C nicht dargestellt, vergleiche dazu aber FIGs. 1A und 1B) insbesondere geöffnet ist, weshalb die analoge Regelschleife 40 für das Tracking nicht existiert (siehe zum Vergleich demgegenüber die FIG. 1B), weshalb dieser entsprechend zur Vereinfachung nicht dargestellt ist, auch wenn die Bauteile für die Implementierung der analogen Regelschleife 40 durch Schluss des Schalters S2 existieren, um in die Sample-Konfiguration überführt zu werden, wie sie in FIG. 1B dargestellt ist.

Zum Übergang in den Sample-Betrieb zur Messung und Speicherung der Offsetrechenspannung V1a wird insbesondere bei der in FIG. 1B dargestellten Sample-Konfiguration der Rechenschaltung 1, der Schalter S2 geschlossen, während der Schalter S1 (siehe FIGs. 1A und 1C) entsprechend geöffnet ist, um den Pfad 20 zu unterbrechen und stattdessen den Pfad 15 ausbilden zu können.

Wie in der FIG. 1A und entsprechend vereinfacht in FIG. 1B gezeigt wird eine, insbesondere geschlossene, Feedbackschleife, auch als Rückkopplungsschleife 10 zu bezeichnen, und eine analoge Speicherung der Summe aller Größen von Offsetspannungen, insbesondere als eine Offset-Rechenspannung V1a, im (operativen Betrieb) gerouteten Rechenpfad 20 mit Hilfe einer Sample-and-Hold-Schaltung SH zur Kompensation der Größen von Offsetspannungen verwendet. Dadurch kann die Wirkung der Offsetrechenspannung V1a während einer Rechnung durch einen injizierten Kompensationsstrom Ioff für den gerouteten Pfad 20 nahezu vollständig aufgehoben werden.

Dazu kann die Offsetrechenspannung V1a (unmittelbar) vor der Rechnung bei am Rechenpfad 20 angelegter NULL durch eine geschlossene, insbesondere analoge, Regelschleife 40 via eines Widerstands R3, wie er in den FIGs. 1A bis 1C exemplarisch dargestellt ist, annähernd eliminiert werden. Der Offset kann dann analog als Ladung bei unterbrochener, insbesondere analogen, Regelschleife 40 (siehe FIG. 1C) gehalten und bei weiterhin unterbrochener, insbesondere analogen, Regelschleife 40 (siehe auch FIG. 1C) während der Rechnung via dem Widerstand R3 als Strom loff so in die Rechenschaltung 1 injiziert werden, dass die Rechnung offsetbereinigt durchgeführt werden kann. Dabei wird insbesondere die "Stellung" der Schalter S1 und S2 gegenüber der in FIGs. 1A und 1B dargestellten geschlossenen, insbesondere analogen, Regelschleife 40 in den jeweils anderen Zustand "umgelegt", also umgeschaltet.

Der Vorteil der analogen Methode mittels Sample-and-Hold-Schaltung SH liegt vor allem darin, dass die Offsetkompensation mittels der Sample-and-Hold-Schaltung SH völlig ohne Operationen im Hybridcontroller den weitestgehend exakten Kompensationsstrom loff durch die analoge Regelschleife 40 als Rückkopplungsschleife 10 ermitteln kann.

Dieser Vorteil kompensiert insbesondere auch den etwas höheren analogen Schaltungsaufwand, wie auch die bei allen kapazitiven Lösungen durch Leckströme begrenzte Speicherzeit. Nach Ablauf der Speicherzeit kann der Offset neu ermittelt werden oder die Rechnung kann alternativ mit verringerter Genauigkeit der Offsetkompensation fortgesetzt werden.

Da analoge Rechenschaltungen, insbesondere periodisch, zwischen einem IC-, einem OP- und einem HALT-Modus wechseln können, können der Effekt der begrenzten Speicherzeit mindestens teilweise kompensiert werden. Die Offsetrechenspannung V1a kann während der IC- oder HALT-Phase dadurch ermittelt werden, dass am Anfang der Route mit einem analogen Schalter (nicht gezeigt) der Signalweg auf Masse GND geschaltet wird.

In FIG.1A (und entsprechend in vereinfachter Darstellung zum Zwecke der besseren Übersichtlichkeit in FIG. 1B) ist das Prinzip der Offsetkompensation mit Sample-and-Hold-Schaltung SH in geschlossener, insbesondere analoger, Regelschleife 40 als Rückkopplungsschleife 10 dargestellt. Dabei wird hier zur Erklärung des Prinzips eine (erhebliche) Offsetrechenspannung V1a von -10mV auf dem gemessenen Rechenpfad I (20) angenommen, die dem System, etwa in einer analog-digitalen Hybridrecheneinrichtung 100, dauerhaft in Form eines Stromes durch den Spannungs-Strom-Wandler R2 zugeführt werden kann. Während des Samplings, sprich auch während der Detektion, also beispielsweise im IC-Mode, kann der Schalter S2 geschlossen sein, während Schalter S1 geöffnet sein kann, um die Verbindung zum M-Block M zu unterbrechen. Der M-Block M ist hier stellvertretend und rein aus Gründen der Erklärung und zur Vereinfachung der Darstellung und Präsentation der Wirksamkeit der verwendeten Offsetkompensation ein angenommener Identitätsblock mit reiner Strom-Spannungs-Wandlung. Es können hier insbesondere beliebige andere Rechenschaltungen 1 vorgesehen sein, wie sie an anderer Stelle hierin beschrieben sind. Beispiele für solche Rechenschaltungen 1 können ausgewählt sein aus mindestens einem von einem invertierenden Operationsverstärker, einem nichtinvertierenden Operationsverstärker, einem Potenzierer, einem Logarithmierer, einem Differentiator, einem Integrator, einem Potentialdifferenzverstärker, einem Instrumenten-Verstärker, einem Addierer und/oder Subtrahierer, insbesondere mit unterschiedlichen Faktoren, einem Komparator, einem Spannungsfolger, auch Impedanzwandler genannt oder auch anderen, jeweils auch alleine oder in einer beliebigen für eine Berechnung gewünschten Kombination.

Beim Sampling der Offsetrechenspannung V1a stellt sich insbesondere an einem Speicherkondensator C1 weitestgehend exakt die Spannung ein, die durch U3 gepuffert am Knoten SJP des Spannungsteilers R3 und R2 ein Potential von nahezu 0V realisieren kann. Der Schalter S2, Widerstand R4, Operationsverstärker U1, U3 und Widerstand R3 bilden dazu insbesondere in einem eingeschwungenen Zustand eine geschlossene Rückkopplungsschleife 10, die das Potential am Knoten SJP dauerhaft auf nahezu 0 V hält. Prinzipbedingt kommt es hier insbesondere bei realen Bauelementen zu einer kleinen Spannung im µV (sprich "Mikrovolt) Bereich, also nur annähernd 0 V. Jedoch sind an diesem Punkt prinzipbedingt insbesondere keine höheren Spannungen realisiert. Damit kann die Wirkung der Offsetspannung V1a kompensiert werden.

Während der Hold-Phase, also beispielsweise im OP-Mode, kann der Schalter S2 geöffnet und Schalter S1 geschlossen werden. Die zuvor gemessene Wirkung der Offsetrechenspannung V1a kann nun durch die Wirkung eines insbesondere beliebigen neuen Ausgangssignals V1b des vorher gemessenen Pfades 15 überlagert sein Resultierend kann über Schalter S1 dem M-Block die eigentliche Rechengrösse insbesondere offsetbereinigt zugeführt werden. Zu dem an anderer Stelle hierin beschriebenen Kompensationsstrom loff, kann nun entsprechend ein Rechenstrom Im im an anderer Stelle hierin im Detail beschriebenen Pfad 20 fließen.

In entsprechenden Ausführungsbeispielen kann der Widerstand R3 zwischen 2 kOhm (sprich Kiloohm) und 22 kOhm liegen, entsprechend den Widerständen R2 und R3. Die entsprechend gewählte Kombination ist dabei insbesondere von der jeweiligen zu erfüllenden Aufgabe in Bezug auf die implementierte Rechenschaltung 1 abhängig. Widerstand R4 kann dabei insbesondere zwischen 100R und 200R liegen. Der Kondensator C1 liegt insbesondere zwischen 220 nF (sprich Nanofarad) und 1 µF (sprich Mikrofarad). Die Offsetrechenspannung V1a und/oder die Rechenspannung V1b können insbesondere in einem Bereich von 0 bis 1 V liegen, wobei die Grenzwerte ausgeschlossen sein können.

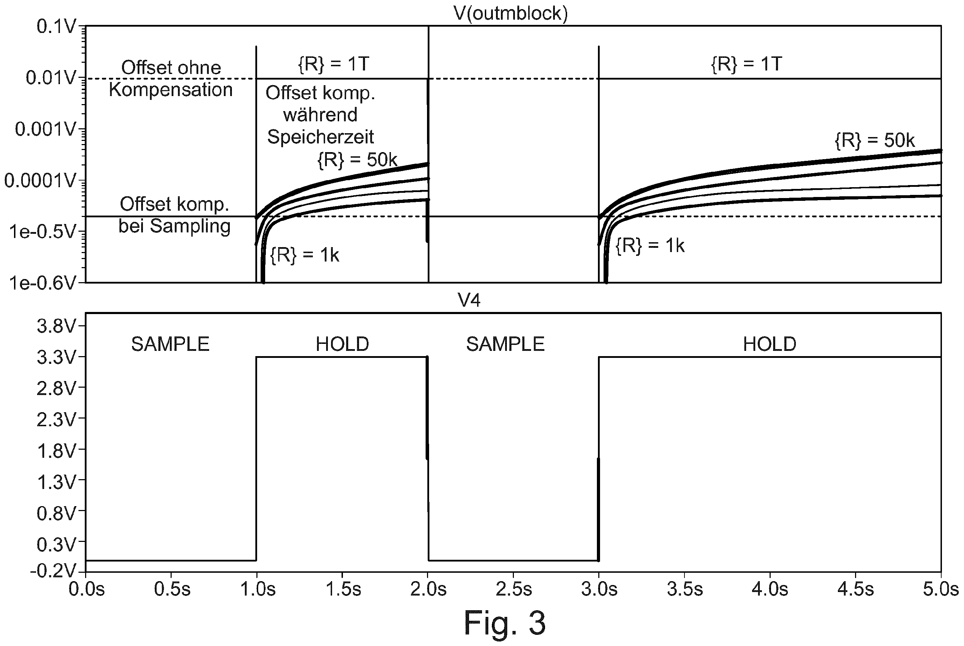

In den in der FIG. 3 dargestellten Diagrammen, die insbesondere aus einer Simulation von Rechenschaltungen 1 mit oben beschriebenen Werten für die entsprechenden Bauteile hervorgehen, wird zur Demonstration und Vergleichbarkeit insbesondere weiterhin von einem NULL-Signal ausgegangen, das zu 100% die Offsetkomponente (die Offsetrechenspannung V1a) enthalten kann. Der Speicherkondensator C1 ist nun insbesondere durch Schalter S2 vom Operationsverstärker U2 getrennt, hält jedoch weiterhin das ursprünglich gesampelte Abbild der Offsetrechenspannung V1a. Via Widerstand R3 kann weiterhin dem Knoten SJP der beim Sampling ermittelte Kompensationsstrom loff entnommen werden. Der Knoten SJP wird nun insbesondere durch den Strom-SpannungsWandler des M-Blocks M (Operationsverstärker U1 und Widerstand R1) auf 0V gehalten, während für die Rechenspannung V1b zusätzlich zur zuvor ermittelten Offsetrechenspannung V1a beliebige Werte vorliegen können, abhängig von der jeweils implementierten Rechnung, da ein Rechenstrom Im fließt, der ein Abbild der Rechenspannung V1b darstellt. Der vorher eingeprägte Kompensationsstrom loff durch Widerstand R3 kann unabhängig davon für die Dauer der Speicherzeit beibehalten und dem Knoten SJP entnommen werden. Der Offset des Pfades 20 bleibt insbesondere weitgehend für die Dauer der Speicherzeit des Kondensators C1 kompensiert.

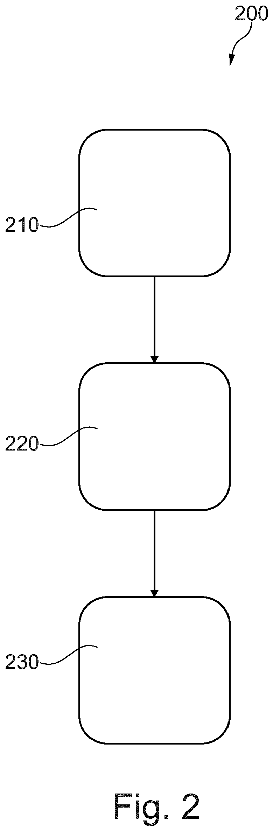

Das Verfahren 200, das durch die Rechenschaltung 1 durchgeführt werden kann, stellt insbesondere eine Kompensation der an anderer Stelle hierin beschriebenen Offset-Fehler dar. Eine exemplarische Ausführungsform des Verfahrens 200 ist entsprechend schematisch in der FIG. 2 gezeigt und diesbezüglich im Folgenden beschrieben, wobei insbesondere auf die Ausführungen zum System bzw. zur Vorrichtung an anderer Stelle hierin Bezug genommen werden kann und wobei entsprechende Merkmale kombiniert werden können, um das Verfahren zu beschreiben, zu erklären und ggf. zu spezifizieren. Aus dem Verfahren 200 resultieren als Beispiel die in FIG. 3 dargestellten Funktionsverläufe, wie sie diesbezüglich beschrieben sind.

FIG. 2 zeigt ein Verfahren 200 zur Ermittlung und zur Kompensation einer Offset-Rechenspannung V1a in einer Rechenschaltung 1. Das Verfahren weist insbesondere den Schritt eines Ermittelns 210 von mindestens einem Kompensationswert einer Offset-Rechenspannung V1a in der Rechenschaltung 1 auf. Wie in Bezug auf die FIG. 1A bis 1C beschrieben, kann das Ermitteln 210 insbesondere ein Sampling der Wirkung der Offsetrechenspannung V1a dadurch ermöglicht werden, dass sich insbesondere an einem Speicherkondensator C1 weitestgehend exakt die Spannung einstellt, die durch den Operationsverstärker U3 gepuffert am Knoten SJP des Spannungsteilers aus Widerstand R3 und Widerstand R2 ein Potential von nahezu 0V realisieren kann. Das Verfahren speist den Kompensationsstrom loff insbesondere bereits beim Ermitteln 210 ein. Es kompensiert ihn so zu NULL. NULL ist hier insbesondere ein theoretischer Wert, da reale Operationsverstärker endliche Gainfaktoren und zusätzliche sich ggf. auswirkende Offsetspannungen aufweisen. Somit bleibt insbesondere auch an einem SJP wenn NULL angestrebt wird eine kleine Spannung stehen, die insbesondere im Bereich µV bis mV liegen kann. Diese geringe Spannung kann in den allermeisten Fällen vernachlässigbar sein, weshalb sie als NULL definiert werden kann. In anderen Worten ausgedrückt kann es sich bei der NULL um Spannungswerte handeln, die durch den Operationsverstärker gegeben sein können, die allerdings vernachlässigbar sein können, etwa für eine entsprechende Anwendung, Berechnung oder Ähnliches. Der Schalter S2, Widerstand R4, Operationsverstärker U1, U3 und Widerstand R3 bilden einen Pfad 15, indem sich ein Stromfluss loff und entsprechende Spannungswerte einschwingen können, um einen eingeschwungenen Zustand auszubilden, der eine geschlossene Rückkopplungsschleife 10 etablieren kann, die das Potential am Knoten SJP dauerhaft auf 0V, bzw. auf die an anderer Stelle hierin beschriebenen Spannungen im µV und/oder mV Bereich halten kann. Damit kann in einem Schritt ein Halten 220 von dem mindestens einem Kompensationswert der Offset-Rechenspannung V1a in der Rechenschaltung 1 ermöglicht werden, wodurch die Wirkung der Offsetspannung V1a kompensiert werden kann. Dies kann insbesondere durch einen Schritt eines Einspeisens 230 eines Kompensationsstromes Ioff zum Kompensieren des mindestens einen Kompensationswerts der Offset-Rechenspannung V1a in der Rechenschaltung 1 während einer Analogrechenoperation erfolgen, insbesondere solange, wie die Speicherzeit des für das Einspeisen relevanten Speicherkondensators C1 dies erlaubt. Für die Rechenoperation kann ein Rechenstrom Im fließen, abhängig von einer Rechenspannung V1b.

FIG. 3 zeigt die Ergebnisse der Simulationen für verschiedene Werte {R} des Widerstandes R3. Der Wert 1 TOhm stellt dabei insbesondere einen Sonderfall dar und zeigt insbesondere das Verhalten ohne wirksame Kompensation. Werte von 50 kOhm bis zu 1 kOhm zeigen insbesondere eine deutliche Verkleinerung der wirksamen Offsetrechenspannung V1a. Es ist zu sehen, dass selbst nach langen HOLD-Perioden der Sample-and-Hold-Schaltung SH von bis zu 2 Sekunden Reduktionen der Offsetrechenspannung V1a, beispielsweise um einen Faktor von 25 bei einem {R} von 50 kOhm bis 200 bei einem {R} von 1 kOhm gehalten/sichergestellt werden kann. Die Speicherzeit der Kapazität C1 hängt insbesondere von ihrer Bauart und den Eingangs- und Leckströmen der verbundenen Halbleiter ab. Die Rechnungen auf dem Analogrechner als Analogrecheneinrichtung 25 bzw. dem analogen Teil einer analog-digital Hybridrecheneinrichtung 100 kann innerhalb weniger Millisekunden ablaufen. Alternativ oder zusätzlich kann eine Rechnung auch nach Unterbrechung zum Resampling der Offsetrechenspannung V1a fortgesetzt werden. Damit kann eine Einschränkung durch die ermittelte Speicherzeit reduziert bzw. umgangen werden.

Insbesondere beziehen sich die Begriffe "können" oder "kann" auf optionale Merkmale der Erfindung. Folglich gibt es auch weitere Aspekte und/oder Ausführungsformen der Erfindung, die zusätzlich oder alternativ das jeweilige Merkmal oder die jeweiligen Merkmale aufweisen. Alle Merkmale in Feature-Kombinationen werden auch unabhängig davon offengelegt und können auch aus den hier offenbarten Kombinationen von Merkmalen herausgegriffen und in Kombination mit anderen Merkmalen verwendet werden, um den Gegenstand eines der Ansprüche zu spezifizieren, wobei jede strukturelle und/oder funktionale Beziehung, die zwischen den Merkmalen bestehen kann, aufgelöst wird. Begriffe wie "erste", "zweite", "dritte" können verwendet werden, um sich auf eine Liste von Elementen zu beziehen, beschreiben diese Merkmale oder Elemente jedoch nicht unbedingt nach ihrer Bedeutung, ihrer Reihenfolge des Aussehens oder der Reihenfolge der Struktur. Daher können diese Elemente oder Merkmale die verschiedenen Aspekte in einer anderen bestimmten Reihenfolge angeben, sofern nicht ausdrücklich anders angegeben.

### BEZUGSZEICHENLISTE

1 Rechenschaltung
10 Rückkopplungsregelschleife
15 Pfad
20 Pfad
25 Analogrecheneinrichtung
30 analog-digitale Hybridrecheneinrichtung
40 analoge Regelschleife
50 analoger Rechenschaltkreis
100 Hybridrecheneinrichtung200Verfahren
210 Ermitteln von mindestens einem Kompensationswert
220 Halten von mindestens einem Kompensationswert
230 Einspeisen eines Kompensationsstromes zum Kompensieren des mindestens einen Kompensationswerts
C1 Kondensator
I Offsetkompensationsschaltung (enthält öffen- und schließbare Regelschleife sowie Sample- and Hold-Schaltung)
C beliebiger zuführender Rechenpfad
loff Kompensationsstrom
Im Rechenstrom
M M-Block (beliebiges offsetbereinigt zu versorgendes Rechenelement)
outOffsetKomp Ausgang des Operationsverstärkers zur Kompensation einer Offsetrechenspannung
outMBlock Ausgang des exemplarischen Operationsverstärker des exemplarischen Rechenblocks M
R1, R2, R3, R4 Widerstände
SH Sample-and-Hold-Schaltung
SJP Knoten als summing junction pointS1, S2 gesteuerte Schalter
Sw, Sw_inv SchalterstellungenU1, U2, U3 Operationsverstärker
V1a (Summe aller) Offsetrechenspannung(en)
V1b Rechenspannung
V1, V2, V3 Betriebspannung der zugehörigen Operationsverstärker U1, U2, U3
V4 Steuerspannung der Analogschalter

## Patentansprüche

1. Rechenschaltung (1), insbesondere einer Analogrecheneinrichtung (25), weiter insbesondere einer analog-digitalen Hybridrecheneinrichtung (100, 30), aufweisend einen Analogrechenschaltkreis (50), ausgebildet und eingerichtet, um eine analoge Rechenoperation auszuführen; und aufweisend eine Detektions- und Kompensationsschaltung (I) enthaltend eine temporäre analoge Speicherschaltung (Engl.: Sample and Hold Circuit, SH), ausgebildet und eingerichtet, um im Analogrechenschaltkreis (50) eine Offset-Rechenspannung (V1a) zu detektieren und um eine Kalibrierung in Bezug auf die Offset-Rechenspannung(V1a) durchzuführen.

2. Rechenschaltung (1) nach Anspruch 1, **dadurch gekennzeichnet, dass** die Detektions- und Kompensationsschaltung (I) eine Rückkopplungsschleife (10) aufweist, die ausgebildet und eingerichtet ist, um einen Kompensationswert für die Offset-Rechenspannung (V1a) zu ermitteln.

3. Rechenschaltung (1) nach einem der Ansprüche 1 oder 2, insbesondere nach Anspruch 2, **dadurch gekennzeichnet, dass** die Detektions- und Kompensationsschaltung (I) mit Hilfe der analogen, temporären Speicherschaltung (SH) den Kompensationswert hält.

4. Rechenschaltung (1) nach einem der voranstehenden Ansprüche, **dadurch gekennzeichnet, dass** die Rechenschaltung (1) einen zusammenfassenden Kreuzungspunkt (Engl.: summing junction point, SJP) aufweist, ausgebildet und eingerichtet, um während der analogen Rechenoperation einen Justagestrom (Ioff) zur Kompensation in Höhe des Kompensationswertes in den Analogrechenschaltkreis (50) einzuspeisen.

5. Rechenschaltung (1) nach einem der voranstehenden Ansprüche, insbesondere nach Anspruch 2, **dadurch gekennzeichnet, dass** die Rückkopplungsschleife (10) ausgebildet und eingerichtet ist, um als geschlossene Regelschleife (40) beim Ermitteln (Engl.: Sampling, 210) und/oder als offene Regelschleife (40) beim Halten (220) der Offsetgröße als Kompensationswert, die Offset-Rechenspannung (V1a) bei der Analogrechenoperation zu kompensieren.

6. Analog-digitale Hybridrecheneinrichtung (30, 100), aufweisend eine Rechenschaltung (1) nach einem der voranstehenden Ansprüche.

7. Hybridrecheneinrichtung (30) nach Anspruch 6, **dadurch gekennzeichnet, dass** die Rechenschaltung (1) derart ausgebildet und eingerichtet ist, um eine Offset-Rechenspannung (V1a) ohne Rückgriff auf eine Hybridcontrollerarchitektur zu kompensieren.

8. Verfahren (200) zur Ermittlung und zur Kompensation einer Offset-Rechenspannung in einer Rechenschaltung (1), insbesondere in einer Rechenschaltung (1) gemäß einem der Ansprüche 1 bis 5, aufweisend mindestens einen der Schritte:
• eines Ermittelns (210) von mindestens einem Kompensationswert einer Offset-Rechenspannung (V1a) in der Rechenschaltung (1);
• eines Haltens (220) von dem mindestens einem Kompensationswert der Offset-Rechenspannung (V1a) in der Rechenschaltung (1); oder
• eines Einspeisens (230) eines Kompensationsstromes zum Kompensieren des mindestens einen Kompensationswerts der Offset-Rechenspannung (V1a) in der Rechenschaltung (1) während einer Analogrechenoperation.
